# EUROPEAN PATENT APPLICATION

(11) **EP 4 776 799 A1**
(43) Date of publication of application: **15.07.2026**
(21) Application number: 25150943.6
(22) Date of filing: 09.01.2025
(51) Int. Cl.: H10H 20/01, H10H 29/03

(54) **METHOD OF PROCESSING SEMICONDUCTOR DEVICES**

(71) Applicant: QubeDot GmbH, 38100 Braunschweig (DE)
(72) Inventor: AGLUSCHEWITSCH, Vladislav, 38110 Braunschweig (DE); BRÜNING, Heiko, 26919 Brake (DE); GÜLINK, Jan, 38106 Braunschweig (DE)
(74) Representative: Hartig, Michael

(57) **Abstract**

A method of processing semiconductor devices, comprising: providing a donor substrate (1) comprising a donor layer (3) having multiple semiconductor devices (7) adjacent to each other, the donor layer (3) arranged on a surface of the donor substrate (1); positioning a receiver substrate (5) opposite the donor substrate (1), with the donor layer facing the receiver substrate (5); and introducing energy at the interface between the donor substrate (1) and the donor layer (3) in an area that corresponds to at least one semiconductor device (7) to detach the at least one semiconductor device (7) of the multiple semiconductor devices (7) from the donor layer (1) and depositing the detached semiconductor device (7) on a target location of the receiver substrate (5).

## Description

### FIELD OF THE DISCLOSURE

The present disclosure relates to a method and system for processing semiconductor devices like surface-mount device (SMD) light-emitting diodes (LEDs) or power electronic devices. Specifically, the present disclosure pertains to a method for transferring semiconductor devices from a donor substrate to a receiver substrate, and to a semiconductor package produced by this method.

### BACKGROUND OF THE INVENTION

In the field of surface-mount device (SMD) light-emitting diodes (LEDs), it is common to employ various methods for transferring and positioning LEDs onto receiver substrates. Known systems typically involve the use of pick-and-place machines, which physically pick up individual LEDs from a donor substrate and place them onto a receiver substrate. This process, while effective, often encounters limitations in terms of precision, speed, and the ability to handle very small LED dies. Additionally, the mechanical nature of pick-and-place systems can lead to potential damage to the delicate LED components, resulting in lower yield and increased production costs. In addition, pick-and-place is limited by the fact that only one surface of the LED die is accessible for picking the die, where only the second surface is open for connecting it to the SMD or any other carrier. If this is not the surface to be connected to the SMD carrier or any other carrier, then a complex double-step process needs to be encountered. In this case, the LED die has to be turned around, so that top and bottom surface are exchanged. This additional step is time-consuming and adds potential contaminants and failures.

Despite the substantial advances in the field of SMD LED processing, there remains a need for improved methods that can enhance the precision and efficiency of LED transfer and placement. Current methods often struggle with handling very small LED dies, maintaining high throughput, and ensuring the integrity of the LEDs during the transfer process. Additionally, there is a need for methods that can facilitate the integration of LEDs onto various types of receiver substrates, including those with different material properties and surface characteristics.

The challenges, which are particularly evident in the fabrication of SMD LEDs with very small diameters, are also prevalent for any other semiconductor devices with small size, independent of its application and material, like e.g. for silicon dies with logic, analog or high-power circuits as well as for any other semiconductor chip with small dimensions.

It is therefore a technical problem underlying the present invention to provide a method of processing semiconductor devices that at least partially overcomes the disadvantages of known systems.

### SUMMARY OF THE DISCLOSURE

It is an objective of this invention to provide a method of processing semiconductor devices that overcomes one or more of the disadvantages of known methods.

A first aspect of the invention provides a method of processing semiconductor devices, comprising: providing a donor substrate comprising a donor layer having multiple semiconductor devices adjacent to each other on a surface of the donor substrate; positioning a receiver substrate opposite the donor substrate, with the donor layer facing the receiver substrate; and introducing energy at the interface between the donor substrate and the donor layer in an area that corresponds to at least one semiconductor device to detach the at least one semiconductor device of the multiple semiconductor devices from the donor layer and depositing the detached semiconductor device on a target location of the receiver substrate.

The adjacent placement pattern of multiple semiconductor devices such as SMD LEDs or power electronic devices on the donor substrate can comprise all kinds of geometries, with semiconductor devices directly touching each other (zero distance) or with a certain distance between neighbored semiconductor devices, which can be smaller or larger in comparison to the semiconductor device dimensions, and can even be much larger than the semiconductor device dimensions. Neighbored semiconductor devices are not required to necessarily be of the same type, size, die thickness or material, but can differ substantially from each other in all parameters. The distribution of different types of semiconductor devices and their positions across the donor substrate is not required to be periodic, but can even be a statistic distribution of semiconductor device positions and types with widely varying semiconductor device parameters, like size, die thickness, wavelength, etc. In addition, both surfaces of the semiconductor devices on the first substrate (top and bottom surface) are not required to be flat but can have substantial height differences across one semiconductor device die and between semiconductor device dies, as is often the case.

According to the method, energy is introduced at the interface between the donor substrate and the donor layer in a specific area that corresponds to at least one semiconductor device. This energy application detaches the selected semiconductor device from the donor layer and gives the detached semiconductor device an impulse that allows it to be transferred onto a target location on the receiver substrate. Thus, the energy supplied to the semiconductor device is sufficient to detach the semiconductor device and give the semiconductor device a sufficient kinetic energy to transfer and fix the semiconductor device on the receiver substrate for example in a single laser "shot". The energy application may also cause a material sublimation in the donor layer or the donor substrate and a pressure change at this location which transfers the detached semiconductor device to the receiver substrate. The receiver substrate can be a package, in particular a semiconductor package.

One preferable way of applying energy to a defined area of the carrier is to use radiation energy, which can be sourced from a laser. However, any other way of applying energy in a site-selective way is also possible, e.g. by local resistive heating with an electrical current, radiation from an incoherent light-source like an LED or any other external light source, or even chemical energy emerging from a local chemical reaction.

The terms used in this application include the donor substrate, which is the initial platform holding the donor layer and the semiconductor devices such as LEDs. The donor layer is the specific layer on the donor substrate which includes the semiconductor devices. The receiver substrate is the platform onto which the detached one or more semiconductor devices are deposited. The interface refers to the boundary between the donor substrate and the donor layer where energy is applied effecting the detachment and transfer of the one or more semiconductor devices.

The advantages of this method include the precise and efficient transfer of semiconductor devices from the donor substrate to the receiver substrate without any use of mechanical tools like gripping and transfer tools. By preferentially using radiation energy, particularly from lasers, the process allows for controlled detachment and placement of semiconductor devices, which can enhance the accuracy and quality of semiconductor device positioning on the receiver substrate. Another advantage is the high flexibility in terms of position, size, die thickness and any other semiconductor device parameters, which can be processed with the same machine, in the same process, one-by-one, all different. It is not required to change e.g. pick-and-place equipment when die area changes. Additionally, a thinning of the donor substrate is also not required which, however, would be the case if the semiconductor devices are very small and the conventional method to produce semiconductor devices would have been carried out. The proposed method improves the manufacturing process of semiconductor devices such as SMD LEDs by reducing waste and increasing throughput and flexibility, as it allows for the selective transfer of semiconductor devices without the need for mechanical handling.

According to an embodiment, the energy is radiation energy from a radiation source, and the radiation source can be a CO2 laser, an excimer laser, a pulsed laser with or without frequency multiplication or any combination thereof.

According to an embodiment, the method includes focusing the laser at the interface, with the beam waist of the focused laser at the interface corresponding to the area of the surface of at least one semiconductor device on the surface of the donor substrate, and wherein the laser interacts with the donor layer at the interface to detach the semiconductor device.

A precise focusing mechanism may ensure that the laser energy is concentrated exactly at the interface where the donor layer, in particular, a single semiconductor device included in the donor layer, and the donor substrate meet, enhancing the efficiency and accuracy of the detachment process. By focusing the laser beam waist at the interface of this particular semiconductor device, the method ensures that the energy is delivered where it is needed, minimizing the risk of damaging adjacent semiconductor devices or other components on the donor substrate. This focused interaction allows for a controlled and localized application of energy. However, it should also be mentioned that the beam waist can be increased so that more than one semiconductor device like for example 2, 4, 6, 10, 20, 100, etc. semiconductor devices are detached and transferred in a single transfer process.

According to an embodiment, the method includes moving the laser to a location over the donor substrate so that the focus of the laser beam is at a semiconductor device or at several preferably adjacent semiconductor devices intended for detachment of the multiple semiconductor devices of the donor substrate.

This movement ensures that the focus of the laser beam is directly at least at one semiconductor device intended for detachment from the multiple semiconductor devices present on the donor substrate. Precision in laser positioning and focus is crucial for the successful transfer of semiconductor devices from the donor substrate to the receiver substrate.

According to an embodiment, the method further includes positioning the donor substrate with the donor layer over the receiver substrate. According to the embodiment, the donor substrate, which holds the donor layer with multiple semiconductor devices such as LEDs or other semiconductor devices or combinations thereof, is positioned in such a way that the semiconductor device or multiple semiconductor devices intended for detachment are directly above the desired target location on the receiver substrate. This precise positioning facilitates the detachment and transfer process, ensuring that the semiconductor device or the multiple semiconductor devices are accurately placed on the receiver substrate. According to an embodiment the receiver substrate may also include devices, in particular semiconductor devices arranged on it when the detachment and transfer process is carried out and the target location can be adjacent to one or more of the devices arranged on the receiver substrate. The devices may be arranged or manufactured on the receiver substrate by other processes than the detachment and transfer process described herein such as photolithography or another mechanical placement process.

According to an embodiment, the method further includes dicing of the donor layer into the multiple LEDs.

The dicing process implies the use of a cutting or separation technique that precisely divides the donor layer into discrete semiconductor device units. This process can involve chemical etching, mechanical cutting, laser dicing, or other precision separation methods. Chemical etching following a photolithographic patterning of a etch resist on the surface is a particularly interesting process, since very small distances between semiconductor devices can be realized. Preferably, the donor substrate is not affected by the dicing process.

According to an embodiment, the method further includes depositing a bonding structure consisting of one or more bonding materials at the target location of the receiver substrate. The bonding structure can be 2D thin film. Alternative bonding structures, like e.g. metal nanowire pads, are also possible.

The step of depositing the bonding structure facilitates the fixed bonding of the detached semiconductor device to the receiver substrate.

According to an embodiment, the bonding material comprises a conductive layer, preferably a conductive glue including a silver glue, nanoporous gold, metal nanoparticles or metal nanowires with or without glue, a low melting point solder or anisotropic conductive adhesive gold/tin (AuSn) solder bumps, conductive silicone or an insulating glue, or a combination thereof.

A silver glue as the bonding material represents a conductive adhesive, which can enhance the electrical connectivity of the LED when it is deposited onto the receiver substrate. This is particularly beneficial in applications where electrical and thermal conductivity is important for the performance of the semiconductor devices, in particular LEDs on the receiver substrate. Insulating glue as a bonding material represents an electrically non-conductive adhesive, which usually goes along with a reduced thermal conductivity. It can be advantageous in applications where electrical or thermal isolation is required, or where the mechanical properties of the glue, such as its adhesive strength or thermal stability, are more critical than its electrical properties. The bonding structure is not necessarily a homogeneous thin film, but can be a mixture of different materials, like e.g. metal nanoparticles or nanowires embedded in any other type of glue.

The bonding material may also comprise or consist of intermediate homogeneous or nonhomogeneous layers, particles, or wires, can serve various purposes, such as enhancing the adhesion of the detached LED to the receiver substrate, providing electrical insulation, or acting as a buffer layer to protect the receiver substrate from potential damage during the semiconductor device transfer process. Furthermore, the intermediate layer can be tailored to possess specific properties, such as thermal conductivity, electrical conductivity, or optical transparency, depending on the requirements of the final application.

According to an embodiment, after the application of the bonding material, structuring of the bonding material may be necessary. This can be done, for example, by a (further) laser, e.g. by partial ablation of the previously applied bonding material to create conductor tracks.

According to an embodiment, the method further includes depositing a conductive layer on the receiver substrate, structuring the conductive layer to include at least two conductive parts separated from each other and depositing the detached at least one semiconductor device on the conductive layer so that each of at least two electrical contacts of the semiconductor device gets in contact with one of the conductive parts of the at least two conductive parts.

According to this embodiment an electrically connected semiconductor device is produced by depositing the semiconductor device on the conductive layer. The structuring of the conductive layer to include at least two conductive parts separated from each other can be done for example by laser ablation of a strip of the conductive layer after its deposition on the receiver substrate to generate a channel between the two conductive parts of the conductive layer. The channel electrically separates the two conductive parts of the conductive layer from each other. Each of the conductive parts of the conductive layer can be connected to respective electrical contact pads provided on or in the receiver substrate. The method permits very precise deposition of the semiconductor device or of several semiconductor devices adj acent to each other with their contacts positioned in contact with the two conductive parts of the conductive layer in an area below 100 x 100 µm2.

According to an embodiment, the donor substrate is a sapphire wafer and the donor layer comprises GaN.

The use of a sapphire wafer as the donor substrate may be useful due to its excellent thermal and optical properties. Sapphire has a high thermal conductivity and transparency to a wide range of wavelengths, which can be particularly beneficial when using radiation energy, such as from a CO2 laser, an excimer laser, or a pulsed laser, as specified above. The transparency of sapphire allows the radiation energy to pass through without significant absorption, ensuring that the energy is effectively delivered to the interface between the donor substrate and the donor layer. This can lead to a more efficient detachment of the semiconductor devices from the donor layer and their subsequent deposition on the target location of the receiver substrate.

Furthermore, GaN is a semiconductor material with a wide bandgap, high electron mobility, and high thermal stability. These properties make GaN particularly suitable for high-power and highfrequency applications. The inclusion of GaN in the donor layer can enhance the performance and reliability of the LEDs being processed. The combination of a sapphire wafer and a GaN donor layer represents a method optimized for high-performance LED applications, potentially improving the thermal management and electrical characteristics of the resulting LED devices. Other semiconductor materials such as GaAs, InAs can be used as well.

According to an embodiment, the size of the target location of the receiver substrate is smaller than 500 x 500 µm² or smaller than 100 x 100 µm². The preferential size of an SMD LED die as the receiver substrate is smaller than 200 x 200 µm².

The size constraint characterizes the preciseness of the deposition process on the receiver substrate which enables use of significantly smaller receiver substrate targets such as SMD LED dies than in the prior art. The size of the SMD LED die smaller than 200 x 200 µm² enhances the method by tailoring it to applications requiring the processing of very small LED dies. The method according to invention can also be used for larger die sizes.

According to an embodiment, an area on the receiver substrate covered by multiple adjacent semiconductor devices such as a larger area of a SMD LED device is achieved by clustering several semiconductor devices such as LEDs together.

According to an embodiment, the several semiconductor devices clustered together include at least two LEDs emitting different wavelengths.

According to an embodiment the several semiconductor devices clustered together can be detached from the donor substrate in subsequent steps, wherein in one step groups of one or more semiconductor devices are detached from the donor substrate and deposited on the target location. This also includes that several semiconductor devices clustered together are transferred in one step together to the target location.

Clustering smaller LEDs together to achieve a larger emission area enhances the versatility and applicability of the method by allowing for the creation of LED devices with varying sizes and configurations. This can be particularly advantageous in applications where larger LED devices are desired, but manufacturing constraints or material limitations necessitate the use of smaller individual LEDs. In addition, LEDs emitting different wavelengths can be clustered in order to achieve multi-wavelength emission.

A second aspect of the invention provides a semiconductor package comprising a receiver substrate; at least one semiconductor device deposited at a target location on a receiver substrate using a method of semiconductor device processing as described above, wherein the at least one semiconductor device on the receiver substrate covers an area of less than 100 x 100 µm². The semiconductor device may include several smaller semiconductor devices clustered together each having an area of only 5x5 µm or larger semiconductor devices of 10x10 µm, 20x20 µm or 40x40 µm.

The target location on the receiver substrate where the at least one semiconductor device is deposited can be equal or smaller than 500 x 500 µm², equal or smaller than 200 x 200 µm² and preferably equal or smaller than 80 x 80 µm².

The small target location on the substrate where the one or more semiconductor devices are deposited which highlights the precision and miniaturization involved in the placement of the one or more semiconductor devices. This small target area allows for compact and efficient design, which is advantageous in applications requiring high-density LED arrangements or where space is limited.

The precision and miniaturization of the semiconductor package is made possible by the present invention by the transfer of a semiconductor device such as an LED by a single laser shot that detaches the LED from the donor layer and imparting sufficient kinetic energy to it to transfer it to and fix it on the receiving substrate, which has a suitable bonding structure as described above.

According to an embodiment the receiver substrate comprises a conductive layer arranged between the at least one semiconductor device and the receiver substrate, wherein the conductive layer comprises at least two conductive parts separated from each other and wherein each of at least two electrical contacts of the at least one semiconductor device are connected with each of the at least two conductive parts.

The at least two electrical contacts of the at least one semiconductor device are preferably arranged on the bottom surface of the at least one semiconductor device and are between the conductive layer and the at least one semiconductor device when the at least one semiconductor device is detached from the donor substrate and contact the conductive layer when the at least one semiconductor device is deposited on the receiver substrate.

According to an embodiment the receiver substrate comprises contacts or contact pads for contacting each of the at least two conductive parts of the conductive layer separated from each other on which the at least one semiconductor device is deposited.

Further features, advantages and characteristics of the invention result from the attached description of the embodiments of the present invention in combination with the attached drawing, in which
- Fig. 1: shows an embodiment of a laser beam focusing on a donor substrate and a donor layer to detach an LED according to an embodiment of the invention;
- Fig. 2: shows an illustrative diagram of a production line for SMD LEDs according to an embodiment of the invention;
- Fig. 3: shows part of a semiconductor package having a LED deposited thereon according to an embodiment of the invention in across sectional side view; and
- Fig. 4: shows the semiconductor package in a view from the top.

### DETAILED DESCRIPTION OF THE EMBODIMENTS

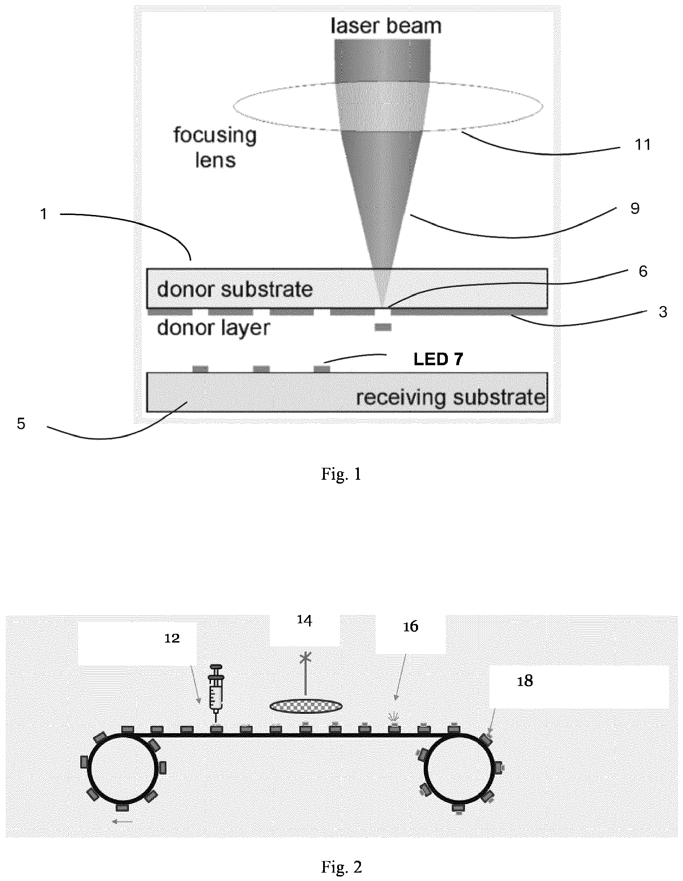

Figure 1 shows a schematic representation of a method for processing SMD LEDs using a laser-based technique according to one embodiment. Figure 1 illustrates the interaction between a donor substrate 1, a donor layer 3, and a receiving substrate 5. The donor substrate 1 supports the donor layer 3, which contains multiple LEDs 7. The receiving substrate 5 is positioned opposite the donor substrate 1, preferentially with small distance. A laser beam, generated by a radiation source 9, is focused through a focusing lens 11 onto the interface 6 between the donor substrate 1 and the donor layer 3. The focused laser beam interacts with the donor layer 3 at the interface 6, causing the detachment of at least one LED 7 from the donor layer 3. The detached LED 7 obtains sufficient kinetic energy by the laser beam so that it is then transferred to a target location on the receiving substrate 5 opposite the original position of the LED 7 in the donor layer 3. The receiving substrate 5 can be a semiconductor package and the target location can be as small as 100x100 µm².
Figure 2 illustrates a production line for processing SMD LEDs, highlighting several key stages in the process. The first stage 12 involves the application of a bonding material onto the receiving substrate 5. This bonding material ensures that the detached LEDs 7 will adhere to the receiving substrate 5. After the application of the bonding material, it may be necessary to structure it. This can be done, for example, by a (further) laser, e.g. by partial ablation of the previously applied bonding material to create conductor tracks. The laser stage 14 initiates the transfer process, where the laser detaches the LEDs 7 from the donor layer 3 and transfers them onto the receiving substrate 5 such as a semiconductor package. Following this, an IVL-Test (In-line Visual Inspection Test) is conducted at stage 16 to ensure the quality and proper placement of the LEDs. At the final stage 18 the SMD LEDs have been packaged and quality-controlled and are ready for further tests, further processing or distribution.

The figures collectively depict a methodical approach to SMD LED processing, emphasizing the precision and automation involved in the detachment and deposition of LEDs from a donor substrate to a receiving substrate, followed by quality assurance steps to ensure the reliability of the final product.

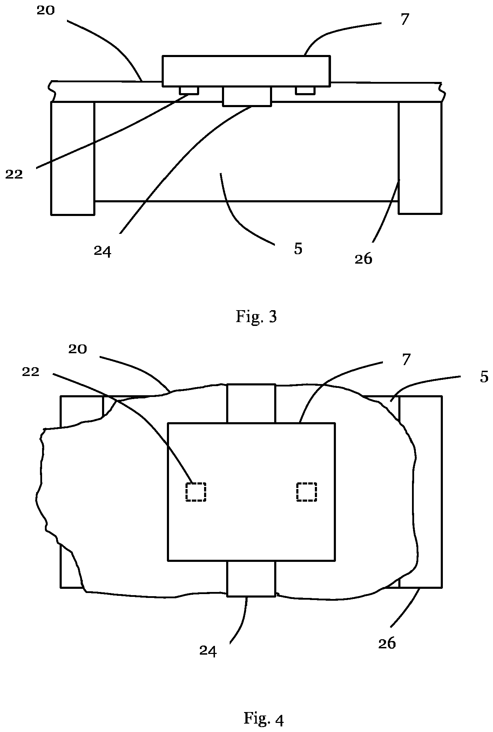

Figure 3 shows a part of a semiconductor package according to an embodiment of the invention in a cross-sectional side view, while Fig. 4 shows the semiconductor package in a view from the top. The semiconductor package comprises a receiver substrate 5 having two contacts 26 provided on two sides of a section of the receiver substrate 5 located there between. On top of the receiver substrate 5 a conductive layer such as silicone is provided as a bonding material 20 for a LED 7 which has been deposited by detaching it from a donor layer 3 on a donor substrate 1 and transferring it to the receiver substrate 5 as described above. The LED 7 has contact pads 22 mounted on the bottom side which after the transfer of the LED 7 to the receiver substrate 5 form contacts with two separate parts of the bonding material 20. The conductive layer of the bonding material 20 has been processed after its deposition on the receiver substrate 5 with laser ablation to form two conductive traces separated by a channel 24. The conductive traces connect the contact pads 22 of the LED 7 with the respective contacts 26 in the receiver substrate. Thus, the LED 7 on the semiconductor package is electrically connected directly by deposition on the receiver substrate 5.

Various modifications may be applied to the embodiments shown without leaving the scope of the invention as defined in the claims. In particular, the method is not restricted to LEDs, but it can easily be transferred to other materials and chips, like e.g. dies with silicon analog, logic or high power circuits.

### Reference numerals:

1- donor substrate
3- donor layer
5- receiver substrate
7- LED
9- radiation source
12- bonding material application stage
14- laser stage
16- IVL-Test stage
18- Packaging an QC stage
20- bonding material
22- contact pad
24- channel
26- contact

## Claims

1. A method of processing semiconductor devices, comprising:
providing a donor substrate (1) comprising a donor layer (3) having multiple semiconductor devices (7) adjacent to each other, the donor layer (3) arranged on a surface of the donor substrate (1);
positioning a receiver substrate (5) opposite the donor substrate (1), with the donor layer (3) facing the receiver substrate (5); and
introducing energy at the interface (6) between the donor substrate (1) and the donor layer (3) in an area that corresponds to at least one semiconductor device to detach the at least one semiconductor device (7) of the multiple semiconductor devices from the donor layer (3) and depositing the detached semiconductor device (7) on a target location of the receiver substrate (5).

2. The method of claim 1, wherein the energy is radiation energy from a radiation source (9), and wherein the radiation source (9) is a CO2 laser, an excimer laser, a pulsed laser or any combination thereof.

3. The method of claim 2, wherein the method includes focussing the laser at the interface (6), with the beam waist of the focussed laser at the interface corresponding to the area of the surface of at least one semiconductor device on the surface of the donor substrate, and wherein the laser interacts with the donor layer (3) at the interface (6) to detach the semiconductor device (7).

4. The method of claim 2 or claim 3, wherein the method includes moving the laser to a location over the donor substrate (1) so that the focus of the laser beam is positioned at at least one semiconductor device (7) intended for detachment from the multiple semiconductor devices (7) of the donor substrate (1).

5. The method of anyone of the preceding claims, wherein the method further includes positioning the donor substrate (1) with the donor layer (3) over the receiver substrate (5), with a semiconductor device (7) of the multiple semiconductor devices (7) intended for detachment being positioned over the target location on the receiver substrate (5).

6. The method of anyone of the preceding claims, wherein the method further includes dicing of the donor layer (3) into the multiple semiconductor devices (7).

7. The method of anyone of the preceding claims, wherein the method further includes depositing a bonding material (20) at the target location of the receiver substrate (5), causing the deposited semiconductor device (7) to bond with the receiver substrate (5).

8. The method of claim 7, wherein the bonding material (20) comprises a conductive layer, preferably a conductive glue including a silver glue, nanoporous gold, metal nanoparticles or metal nanowires with or without glue, a low melting point solder or anisotropic conductive adhesive gold/tin (AuSn) solder bumps, conductive silicone or an insulating glue, or a combination thereof.

9. The method of anyone of the preceding claims, wherein the method further includes depositing a conductive layer on the receiver substrate (5), structuring the conductive layer to include at least two conductive parts separated from each other and depositing the detached semiconductor device (7) on the conductive layer so that each of at least two electrical contacts (22) of the semiconductor device (7) gets in contact with one of the conductive parts of the at least two conductive parts.

10. The method of anyone of the preceding claims, wherein the donor substrate (5) comprises a sapphire wafer, and the donor layer comprises GaN.

11. The method of anyone of the preceding claims, wherein the method further includes depositing several semiconductor devices (7) adjacent to each other on an area on the receiver substrate (5) to cover the area by multiple adjacent semiconductor devices (7).

12. The method of claim 11, wherein the multiple adjacent semiconductor devices (7) include at least two LEDs emitting different wavelength ranges.

13. A semiconductor package comprising:
a receiver substrate (5);
at least one semiconductor device (7) deposited at a target location on the receiver substrate (5), wherein the at least one semiconductor device on the receiver substrate (5) covers an area of less than 100 x 100 µm².

14. The semiconductor package of claim 13, wherein the receiver substrate (5) comprises a conductive layer arranged between the at least one semiconductor device (7) and the receiver substrate (5), wherein the conductive layer comprises at least two conductive parts separated from each other and wherein each of at least two electrical contacts of the at least one semiconductor device (7) are connected with one of the at least two conductive parts.

15. The semiconductor package of claim 14, wherein the receiver substrate (5) comprises contacts for contacting each of the at least two conductive parts of the conductive layer separated from each other.
